Europäisches Patentamt

European Patent Office (11) Publication number: **0 166 256**

Office européen des brevets **B1**

(12) EUROPEAN PATENT SPECIFICATION

(45) Date of publication of patent specification: 08.08.90 (51) Int. Cl.⁵: **C 23 C 14/34**, G 21 C 3/62

(21) Application number: 85106630.8

(22) Date of filing: 30.05.85

(54) Apparatus for coating nuclear fuel pellets with a burnable absorber.

(30) Priority: 22.06.84 US 623747

(43) Date of publication of application:
02.01.86 Bulletin 86/01

(45) Publication of the grant of the patent:
08.08.90 Bulletin 90/32

(84) Designated Contracting States:
BE DE FR GB IT SE

(56) References cited:
CH-A- 311 230    GB-A- 813 251
DE-A-2 434 652    GB-A-1 497 782
DE-A-2 919 191    US-A-4 080 281
CHEMICAL ABSTRACTS, vol. 86, no. 26, 27th
June 1977, page 433, abstract no. 196633b,
Columbus, Ohio, US; R.L. GIBBY et al.:
"Deposition of chromium, niobium, vanadium,
and titanium coatings on uranium dioxide-
25w/o plutonium dioxide fuel pellets by
sputtering", & REPORT 1976, HEDL-SA-863, 23
pp.
THIN SOLID FILMS, vol. 107, no. 1, September
1983, pages 81-87, Elsevier Sequoia, Lausanne,
CH; J.R. SHAPPIRIO et al.: "Synthesis and
properties of some refractory transition metal
diboride thin films"

(73) Proprietor: WESTINGHOUSE ELECTRIC
CORPORATION
Westinghouse Building Gateway Center
Pittsburgh Pennsylvania 15222 (US)

(72) Inventor: Radford, Kenneth Charles
7200 Beatty Road Apt. P107
Irwin Pennsylvania 15642 (US)
Inventor: Keller, Herbert Willard
113 Atterbury Road
Monroeville Pennsylvania 15146 (US)
Inventor: Parks, Beryl Hugh
129 Duchess Trail
Lexington South Carolina 29072 (US)
Inventor: Fuller, Robert Ray
413 White Falls Drive
Columbia South Carolina 29210 (US)

(74) Representative: Patentanwälte Dipl.-Ing. R.
Holzer Dipl.-Ing. (FH) W. Gallo
Ludwigstrasse 26
D-8900 Augsburg (DE)

## Description

The present invention relates generally to apparatus for depositing coatings on substrates and, more particularly, to apparatus for sputter coating nuclear fuel pellets.

Nuclear fuel pellets have the shape of generally right circular cylinders. The fuel pellets contain fissionable material, such as uranium dioxide, thorium dioxide, plutonium dioxide, or mixtures thereof. The pellets are placed in end-to-end abutment within a cladding tube (typically made of azirconium alloy or stainless steel) to make a fuel rod. The fuel rods usually are grouped together to form a fuel assembly. The fuel assemblies are arranged together to constitute the core of a nuclear reactor.

As known in the art, the life of a fuel assembly may be extended by combining an initially larger amount of fissionable material as well as a calculated amount of burnable absorber. Burnable absorbers are materials (such as boron, gadolinium, samarium, europium, and the like) which have a high probability (or cross section) for absorbing neutrons, resulting in isotopes of sufficiently low neutron capture cross section to be substantially transparent to neutrons, all while producing no new or additional neutrons. The burnable absorber compensates for the larger amount of fissionable material during the early life of the fuel assembly. During reactor operation, the burnable absorbers are progressively reduced in amount, resulting in a longer life at relatively constant fission level for the fuel assembly. Longer fuel assembly life means less frequent nuclear reactor fuel assembly replacement known as refueling which is costly and time consuming.

U.S. Patent 3,427,222 discloses a method of fusion bonding a burnable poison (also known as a burnable absorber) layer to the surface of a nuclear fuel pellet substrate, and Applicant's Patent Application No. (W. E. Case 51,305) discloses sputtering as a method of depositing a layer of burnable poison on nuclear fuel pellets. Sputtering is a process in which an inert gas is introduced into a vacuum chamber containing an anode, the substrate to be coated, and a target cathode. A high voltage is applied across the anode and target cathode to cause the gas molecules to become ionized and to strike the target cathode. This causes atoms and/or molecules of the target cathode to be sputtered from the target cathode's surface. The substrate is positioned to intercept this sputtered target material which forms an adherent coating upon striking the substrate. Sputtering is a generally line-of-sight coating process.

A sputtering apparatus is disclosed in U.S. Patent 4,080,281 for making metal films, such as electrical resistors or electrodes of electrical capacitors. The substrates are placed in an annular cylindrical cage which serves as the anode. The outer coaxial, annular cylindrical target cathode circumferentially surrounds the cage to sputter radially inward on the cage from all directions, including downward. The inner coaxial, rod target cathode lies along the cage's longitudinal axis to sputter radially outward on the cage from all directions, including downward. The cage rotates to cause the metal films to be more uniform.

U.S. Patents 3,562,140 and 3,632,494 disclose sputtering apparatus for coating razor blades with chromium. The razor blades are on a rotating drum. The razor blades are caused to rotate with respect to the drum as the drum rotates, to allow both edges of double-edge blades to be coated from a single target cathode.

The invention has for its principal object to provide apparatus for depositing a coating on nuclear fuel pellets, and accordingly it resides in apparatus comprising (a) a generally cylindrical, hollow drum having at least one open area in the circumference thereof; (b) a pallet for receiving fuel pellets to be coated, said pallet comprising a pair of screened parts which are separably attached to each other face-to-face so as to define therebetween a space for the fuel pellets to be accommodated therein, said space having a depth allowing the fuel pellets to be placed therein only in a single layer, and said pallet being removably mountable within said open space in the circumference of the drum such that the screened parts thereof face in directions substantially radial with respect to the drum; (c) a hermetically sealable chamber into and from which is movable said drum, the latter being supported in said chamber such that the longitudinal axis of the drum is generally horizontal, and said drum having associated therewith drive means for rotating the drum about its longitudinal axis; and (d) means for sputtering said coating onto the fuel pellets contained in the pallet removably mounted on the drum, the sputtering means including at least one stationary upper target and at least one stationary lower target, which upper and lower targets are supported at locations enabling the targets to sputter a coating onto the fuel pellets within said pallet as the drum is rotating, the arrangement being such that, when the drum is within said chamber, said or each upper target is located inside the drum at a level above the longitudinal axis and proximate to the circumference of the drum, and is oriented to face generally upward and radially outward of the drum, and said or each lower target is located outside and below the drum proximate to the circumference thereof and is oriented to face generally upward and radially inward of the drum.

A preferred embodiment of the invention will now be described, by way of example only, with reference to the accompanying drawings, in which:

Figure 1 is a schematic view of a coating apparatus embodying the invention;

Figure 2 is a schematic view showing the drum of the coating apparatus of Figure 1 removed from its chamber;

Figure 3 is a front perspective view of a lower portion of the open or empty chamber of Figure 2 looking inside, and showing stationary lower targets including target tiles;

Figure 4 is a perspective rear view of the drum, which also depicts stationary upper targets;

Figure 5 is a schematic sectional view along line V-V of Figure 1, showing the pellet-containing pallets on the drum together with the accompanying stationary lower and upper targets;

Figure 6 is a planar view, with portions broken away, of one of the pallets of Figure 5 detached from the drum;

Figure 7 is a perspective view of the pallet of Figure 6, with the upper screened part detached from the lower screened part;

Figure 8 is a perspective view of a coated nuclear fuel pellet; and

Figure 9 is an enlarged perspective view of target tiles as removed from one of the stationary lower or upper targets shown in Figures 3 and 4, respectively.

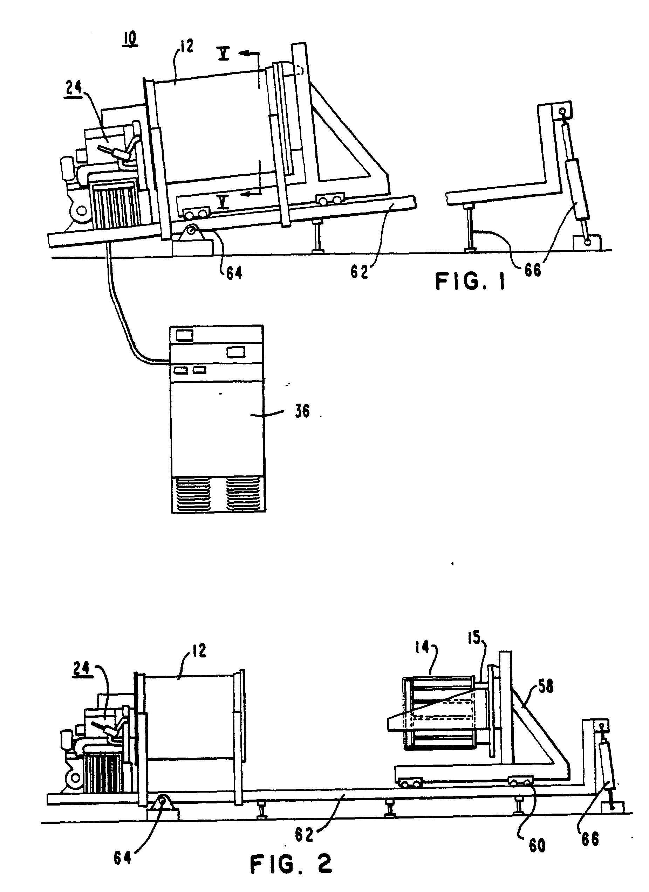

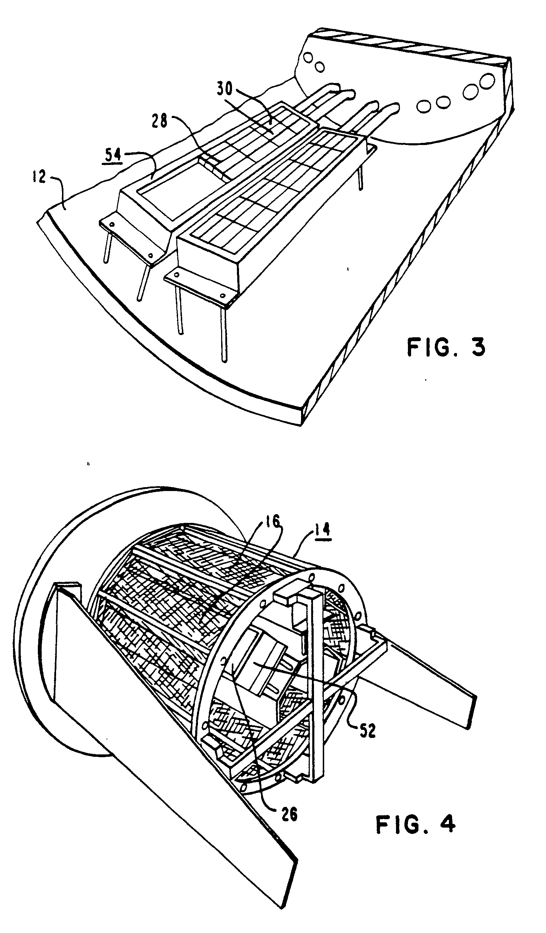

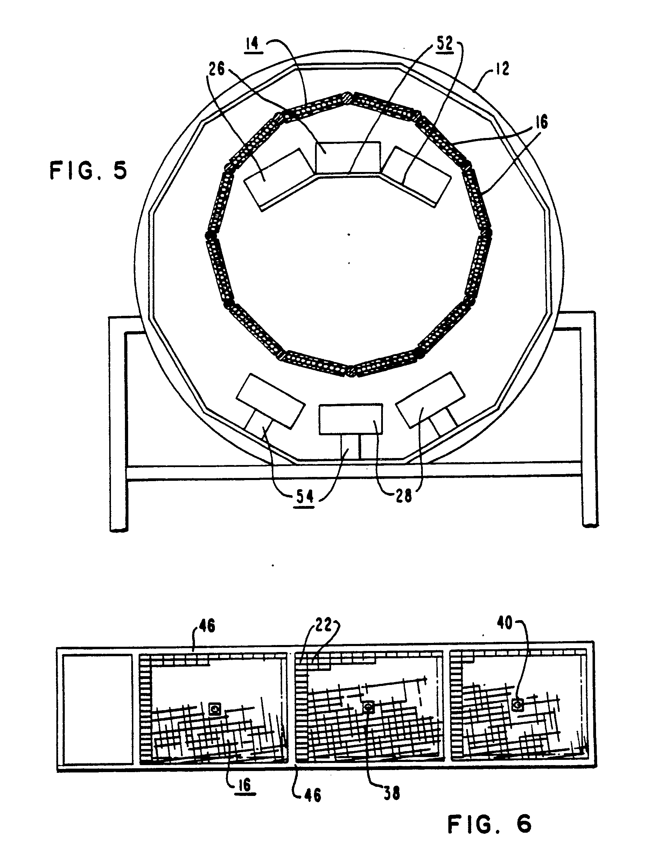

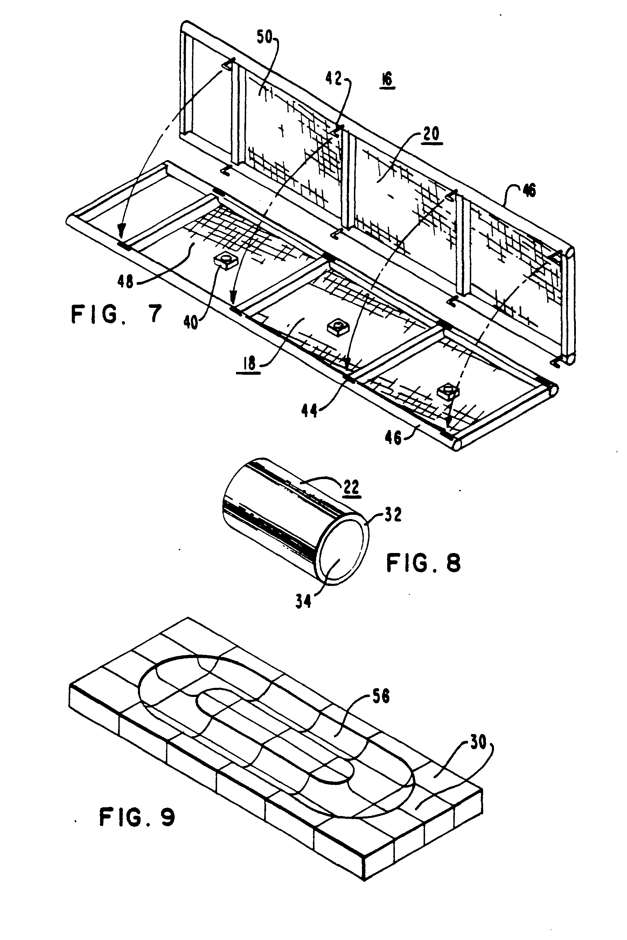

The nuclear fuel pellet coating apparatus 10 shown in Figure 1 includes a chamber 12 (Figs. 1, 2 and 3) and a generally cylindrical, skeletonized drum 14 (Figs. 2, 4 and 5) which is rotatable about its longitudinal axis by a motor 15 (Fig. 2). The drum 14 is hermetically sealable within the chamber 12 (Fig. 1 with drum installed; Fig. 2 with drum removed), with the longitudinal axis of the drum 14 oriented generally horizontally. The drum's circumference has a number of detachable enclosed pallets 16 comprising lower and upper screened parts 18, 20 (Figs. 4, 5, 6 and 7). Each pallet 16 can contain only a single layer of nuclear fuel pellets 22 (Figs. 6 and 8). The coating apparatus 10 also contains a sputtering machine 24 (Figs. 1 and 2) having stationary upper targets 26 (Figs. 4 and 5) and stationary lower targets 28 (Figs. 3 and 5). The targets 26 and 28 each include a number of target tiles 30 (Figs. 3 and 9) which are sputtered as a coating 32 onto the substrate 34 of the nuclear fuel pellet 22 (Fig. 6 and 8). A control console 36 (Fig. l) is used to control the drum motor 15 and the sputtering machine 24.

Typically, each fuel pellet 22 comprises a generally right circular cylindrical substrate 34 of uranium dioxide having a length of approximately 13.5mm and a diameter of approximately 8.20mm, the pellet-shaped substrate being covered with a coating 32 having a thickness of, say, 10 micrometers, and consisting of a burnable absorber, such as zirconium diboride. Other pellet substrate and coating dimensions may be chosen by the designer, as well known in the art. Depending upon the burnable absorber requirements of a particular fuel load, only the circumferential surface of the substrate 34 of each pellet 22, only the middle pellets in a fuel rod, only some of the fuel rods in a fuel assembly, and only some of the fuel assemblies in a reactor core would receive a pellet coating 32. The Applicant found that a zirconium diboride target was a sputter-frangible target, meaning it would break up during the sputtering process. A target is relatively expensive, and a sputter-frangible target sputtering downward would quickly break up and fall away, thereby contaminating the substrates. By sputtering upward, these broken target pieces would continue to participate in the sputtering process. The Applicant also found that target breakup is reduced by using a number of smaller target tiles for the target instead of a single large target tile.

In the sputtering apparatus 10, each of the pallets 16 has a generally rectangular configuration capable of holding only a single layer of fuel pellets 22. This is accomplished by providing a suitable spacing between the lower and upper screened parts 18 and 20. If the spacing between the parts 18 and 20 were such as to allow multiple fuel pellet layers in the pallet, there would be problems, during sputtering, such as pellet chipping or breakage, dusty pellet coatings from pellet attrition, and lack of uniformity in pellet coatings. The upper screened part 20 is detachably fastened to the lower screened part 18 by means of bolts 38 extending through the upper screened part 20 and threaded into nuts 40 secured to the lower screen part 18, and by means of hooks 42 engaged in grooves 44 formed in the screened parts 18 and 20. Thus, the screened parts 18 and 20 are separably fastened together in a manner permitting fuel pellets 22 to be easily loaded and unloaded, respectively, into and from the pallet. The pallet 16 (including its screened parts 18 and 20) is made of a suitable material to which the sputtered material will not adhere. Applicants have found that sputtered zirconium diboride will not adhere to stainless steel. Preferably, the fuel pellets 22 in the pallet 16 are aligned end-to-end into columns and aligned side-by-side into rows (except in the area taken up by the nuts 40). A typical pallet 16 may contain 38 rows and 19 columns of fuel pellets 22.

The skeletonized drum 14 has in its circumference at least one open area for receiving a pallet. Preferably, and as shown, it has several such open areas spaced apart circumferentially about the drum and each adapted to receive one pallet to be disposed therein such that its lower and upper screened parts 18 and 20 face in substantially radial directions. Typically, the drum 14 will hold on its circumference twelve pallets 16 in an array having the cross-sectional shape of a generally equilateral dodecagon. Preferably, the pallets 16 are attached to the drum 14 such that each column of fuel pellets is generally coplanar with and parallel to the drum's longitudinal axis.

Applicant's early experiments produced "striped" fuel pellets, which were coated fuel pellets having uncoated areas where the screened parts 18 and 20 had shielded the fuel pellets from the sputtering target material. Although these striped pellets were found to be satisfactory from a nuclear standpoint, a more uniform coating resulting in "unstriped" fuel pellets was desired. Furthermore, it was found desirable to ensure that the ends of the fuel pellet 22 would not be coated. For example, a boron containing burnable absorber on the ends of the fuel pellets would be undesirable from both a nuclear and a chemical standpoint. To achieve these goals, the lower and upper screened parts 18 and 20 of each pallet 16 were spaced apart at a distance allowing the single layer of fuel pellets 22 a slidable and rollable fit within the pallet. During the sputtering process, the chamber 12 together with the drum 14 enclosed therein is tilted, with respect to the horizontal, at an angle not exceeding ten degrees, and preferably at an angle of approximately five degrees. Such a small angle, which is considered to be included in defining the drum's longitudinal axis as being oriented "generally horizontally", allows pellet circumferences to be coated while preventing the coating deposition on the pellet ends by eliminating any spaces between the ends of the aligned pellets. The side-to-side rolling of the fuel pellets 22 eliminates longitudinal "striping", i.e. the leaving of uncoated areas. The rolling was controlled by the spacing of the parallel side 46 of the pallet 16. These sides 46 retain each pellet row sideways such that, if the row were biased against one of the pallet sides 46, there would be a gap between that row and the other of the pallet sides 46 of between approximately 1.5mm and 0.8mm. Preferably, the gap is approximately 1.2mm for an approximately 8.2mm diameter fuel pellet 22. Transverse uncoated or "striped" areas of the fuel pellets 22 are removed by having the screen grid patterns 48 and 50 of the lower and upper screened parts 18 and 20 of the pallet 16 rotated such that a pellet column projected onto each screen grid pattern defines angles, with respect thereto, of between 5 degrees and 40 degrees, approximately. Preferably, these projected angles are each generally 15 degrees. With this arrangement, a rolling fuel pellet does not come back to its exact same position under the grid so that every circumferential part of the pellet substrate 34 is coated. Rolling pellets in a rotated screen grid eliminated the uncoated striped areas on the fuel pellets 22.

The sputtering machine 24 sputters the coating 32 onto the pellets substrate 34. The technology for the anodes, the cathodes, and the support equipment for sputtering is known in the art and is available commercially. In the embodiment described herein, the drum 14 (including the pallets 16) is made an anode for the sputtering machine 24.

The sputtering machine 24 has upper cathodes 52 supporting the stationary, sputter-frangible, upper targets 26 such that, when the drum 14 is placed within the chamber 12, the upper targets 26 are disposed inside and proximate to the drum's circumference at a location which is above the drum's longitudinal axis. Of course, the upper targets 26 are longitudinally positioned to correspond with the longitudinal position of the drum's open areas. Moreover, the stationary upper targets 26 are oriented to face generally upward and radially outward. Thus, as the sputter-frangible upper targets 26 break up during sputtering, they will be held in their container cathodes 52 and continue to be consumed in the sputtering process. A downward target orientation would cause the fragmented target pieces to fall uselessly away or even to contaminate the surface of any substrate (awaiting to be coated by the sputtered target atoms/molecules) which may be located therebelow. It is important to distinguish between the micro pieces (i.e., atoms/molecules) of the upper targets 26 (or target tiles 30) which are sputtered, and the macro pieces which are fragmented during the sputtering process by certain sputter frangible material, such as zirconium diboride. The upper targets 26 sputter the coating 32 onto those areas of the fuel pellets 22 (pellet substrate 34) in the pallet 16 on the rotating drum 14 which are exposed to the stationary upper targets 26 each time the pallets 16 rotate past.

The sputtering machine 24 also has lower cathodes 54 supporting the stationary, sputter-frangible, lower targets 28 such that, when the drum 14 is placed within the chamber 12, the lower targets 28 are disposed outside and proximate to the drum's circumference at a location which is below the drum's longitudinal axis. The lower targets 28 likewise are longitudinally positioned to correspond with the longitudinal position of the drum's open areas, and they are oriented to face generally upward and radially inward. Concerning target fragmentation, the upward facing lower targets 28 behave like the upward facing upper targets 26 discussed in the previous paragraph. The lower targets 28 sputter the coating 32 onto those areas of the fuel pellets 22 (pellet substrates 34) in the pallet 16 on the rotating drum 14 which are exposed to the stationary lower targets 28 each time the pallet 16 rotates therepast.

Preferably, the stationary upper and lower targets 26 and 28 each are made up of a number of generally identical target tiles 30, each target tile 30 being interchangeable in position with the other target tiles 30 in its target 26 or 28. During sputtering, the target is consumed predominately along a race-track-shaped groove 56 (Fig. 9) due to the dynamics of the process. Since the targets 26 and 28 are expensive, longer target life is achieved by using targets composed of target tiles 30 which can be interchanged in position to expose ungrooved areas during subsequent sputtering runs.

Although sputtering could be accomplished with a single pair of upper and lower targets 26 and 28, it is preferred to have a total of three such pairs for sputtering sputter-frangible material, such as burnable poison zirconium diboride. With such number of circumferentially spaced-apart stationary upper targets 26 and a like number of circumferentially spaced-apart stationary lower targets 28, a higher coating rate is achieved. Also, the controller 36 can sequentially activate different cathode pairs for chosen time periods (where each pair is of the same target material but different pairs are of different materials) to produce duplex or triplex coatings. If a coating, such as a zirconium hydrophobic overcoat, were not associated with a sputter-frangible target, that target could face generally downward and such additional targets could be added to the coating apparatus 10, as will be appreciated by those skilled in the art.

The sputtering process, for high coating deposition rates, heats up the pellet substrates 34. A desired cooling effect which helps to maintain desired coating temperatures is achieved by controlling the revolution rate of the drum 14 combined with the only partial circumferential placement of the upper and lower targets 26 and 28. Thus, a particular area on the pellet substrate 34 (even if it did not roll) will not be constantly exposed to sputtering as the drum 14 rotates. Furthermore, if the targets were in only one location instead of being located in upper and lower positions, the pellet coating could be fractured by thermal shock during the sputtering process. Typical dimensions and operating parameters (not intending to be limiting but merely serving as examples) include a uranium dioxide fuel pellet substrate of 8.2mm in diameter, 13.5mm in length, and 7.8 g. in weight; a pellet array in the pallet of 38 rows and 19 columns; a sideways gap allowing the pellets to roll of between 1.2mm and 3.8mm; screen grids (screen grid patterns) each having a rotation angle of 15° for their 0.7mm diameter stainless steel wires, with parallel wires spaced 6.4mm apart; a chamber tilt of 5° from the horizontal; a drum rotation of 1 revolution per 30 seconds; and a zirconium diboride sputtering rate per cathode pair of 10.2 microns (final coating thickness) in 28 to 30 hours. Each target may be a rectangle measuring 68.5cm x 12.7cm and made up of 4 columns and 6 rows of zirconium diboride target tiles each forming a rectangle of 11.4cm x 3.18cm and having a thickness of 1.0cm.

In operation, the target tiles 30 of the targets 26 and 28 are placed in the cathodes 52 and 54. The pellet substrates 34 are loaded into the pallets 16 which then are secured to the drum 14. The drum 14, which is attached to a support 58, next is moved by support rollers 60 over a frame 62 (which also holds the chamber 12) and is installed in the chamber 12 to form a hermetically sealed unit. The frame 62 then is tilted about a hinge 64 by pistons 66 to an angle of about five degrees from the horizontal. At this point, the control console 36 (operated in manual or automatic mode) controls the sputtering machine 24 and the drum motor 15, as known in the art, to sputter the coating 32 on the pellet substrate 34. After a predetermined time (which may be chosen by experimental sputtering runs), the control console ceases the sputtering operation and returns the system to a state allowing for removal of the fuel pellets 22. At this time, the installation steps described above are reversed, leading to the removal of the fuel pellets 22 for their subsequent use in fuel rods of nuclear reactors.

## Claims

1. Apparatus for depositing a coating on nuclear fuel pellets, characterized by the combination comprising:

(a) a generally cylindrical, hollow drum having at least one open area in the circumference thereof;

(b) a pallet for receiving fuel pellets to be coated, said pallet comprising a pair of screened parts which are separably attached to each other face-to-face so as to define therebetween a space for the fuel pellets to be accommodated therein, said space having a depth allowing the fuel pellets to be placed therein in a single layer, only, and said pallet being removably mountable within said open space in the circumference of the drum such that the screened parts thereof face in directions substantially radial with respect to the drum;

(c) a hermetically sealable chamber into and from which is movable said drum, the latter being supported in said chamber such that the longitudinal axis of the drum is generally horizontal, and said drum having associated therewith drive means for rotating the drum about its longitudinal axis; and

(d) means for sputtering said coating onto the fuel pellets contained in the pallet removably mounted on the drum, the sputtering means including at least one upper target and at least one lower target, which upper and lower targets are stationarily supported at locations enabling the targets to sputter a coating onto the fuel pellets within said pallet as the drum is rotating, the arrangement being such that, when the drum is within said chamber, said or each upper target is located inside the drum at a level above the longitudinal axis and proximate to the circumference of the drum, and is oriented to face generally upward and radially outward of the drum, and said or each lower target is located outside and below the drum proximate to the circumference thereof, and is oriented to face generally upward and radially inward of the drum.

2. Apparatus according to claim 1, wherein the fuel pellets comprise uranium dioxide and the coating includes a burnable absorber consisting essentially of zirconium diboride, characterized in that said pallet, including said upper and lower screened parts, consists essentially of stainless steel.

3. Apparatus according to claim 1 or 2, characterized in that the fuel pellets within said pallet are aligned generally end-to-end in columns and aligned generally side-by-side in rows, and that said pallet, when removably mounted on the drum within said open area in the circumference thereof, is oriented such that each of said columns is generally coplanar with and parallel to the longitudinal axis of said drum, said screened parts being spaced apart a distance allowing said fuel pellets a slidable and rollable fit within the pallet.

4. Apparatus according to claim 3, characterized in that said pallet includes generally parallel spaced sides for retaining the rows of fuel pellets sideways in the pallet, the spacing between said sides being such that if any of the pellet rows were biased against one of said sides, there would be a gap of approximately from 0.8mm to 1.5mm between said pellet row and the other of said pallet sides.

5. Apparatus according to claim 4, wherein each pellet has a diameter of approximately 8.2mm, characterized in that said gap is approximately 1.2mm.

6. Apparatus according to claim 3, 4 or 5, characterized in that each of said screened parts has a screen grid pattern oriented such that any one of said columns of pellets projected onto each screen grid pattern defines an angle of between approximately 5 and 40 degrees with respect thereto.

7. Apparatus according to claim 6, characterized in that said angle is approximately 15 degrees.

8. Apparatus according to any one of the preceding claims, characterized in that during the sputtering of the coating, said chamber, with said drum disposed therein, is tilted with respect to the horizontal at an angle not exceeding 10 degrees.

9. Apparatus according to claim 8, characterized in that said angle is approximately 5 degrees.

10. Apparatus according to any one of the preceding claims, characterized in that said drum has a plurality of open areas in the circumference thereof, each for receiving one said pallet, said open areas being substantially identical to each other and spaced apart circumferentially about the drum.

11. Apparatus according to any one of the preceding claims, characterized in that the sputtering means includes a plurality of each said upper and lower targets, the upper targets being stationarily supported in circumferentially spaced relationship with respect to each other, and the lower targets being stationarily supported in circumferentially spaced relationship with respect to each other.

12. Apparatus according to claim 11, characterized in that at least one of the upper targets and at least one of the lower targets comprise a first material for sputter-depositing said coating upon the fuel pellets, and at least one of the upper targets and one of the lower targets comprise a second and different material for sputter-depositing an additional coating upon the first-mentioned coating, said apparatus including control means for controlling said drive means of the drum and said sputtering means, and said control means being adapted to activate for a predetermined time first the upper and lower targets comprising said first material, and thereafter to activate for a preselected time the upper and lower targets comprising said second material.

13. Apparatus according to any one of the preceding claims, characterized in that each of said upper and lower targets comprises a plurality of substantially identical target tiles which are interchangeable in position with one another.

## Patentansprüche

1. Vorrichtung zur Beschichtung von Kernbrennstofftabletten, dadurch gekennzeichnet, daß sie aufweist:

a) eine im wesentlichen zylindrische, hohle Trommel mit mindestens einem offenen Bereich in deren Umfang,

b) eine Palette zum Aufnehmen der zu beschichtenden Brennstofftabletten welche ein Paar abgeschirmter Teile aufweist, welche einander gegenüberliegend lösbar miteinander verbunden sind, so daß dazwischen ein Raum zum Aufnehmen der Brennstofftabletten gebildet wird, wobei der Raum eine Tiefe aufweist, die ein Anordnen der Brennstofftabletten nur in einer einzigen Lage ermöglicht, und wobei die Palette abnehmbar innerhalb des offenen Raumes am Umfang der Trommel befestigbar ist, so daß dessen abgeschirmte Teile etwa in radiale Richtung bezüglich der Trommel verlaufen,

c) eine hermetisch abdichtbare Kammer, bezüglich welcher die Trommel hinein- und heraus bewegbar ist, wobei die Trommel in der Kammer so gehalten wird, daß die Längsachse der Trommel etwa horizontal verläuft, und wobei die Trommel ihr zugeordnete Antriebsmittel zur Drehung der Trommel um ihre Längsachse aufweist, und

d) Mittel zur Kathodenzerstäubung der Beschichtung auf die Brennstofftabletten, die auf der beweglich auf der Trommel angebrachten Palette liegen, wobei die Zerstäubungsmittel mindestens ein oberes Target und mindestens ein unteres Target aufweisen, wobei die oberen und unteren Targets feststehend an Stellen gehalten sind, die ein Zerstäubungsaufbringen einer Beschichtung von den Targets auf die sich in der Palette befindlichen Brennsofftabletten während der Drehung der Trommel ermöglichen, wobei die Anordung so getroffen ist, daß, wenn die Trommel sich innerhalb der Kammer befindet, das bzw. jedes obere Target innerhalb der Trommel oberhalb der Längsachse und in der Nähe des Umfanges der Trommel angeordnet ist und so orientiert ist, daß es etwa nach oben und radial aus der Trommel heraus weist, und daß das bzw. jedes untere Target außerhalb und unterhalb der Trommel in der Nähe dessen Umfangs angeordnet und so orientiert ist, daß es etwa nach oben und radial in die Trommel weist.

2. Vorrichtung nach Anspruch 1, wobei die Brennstofftabletten Urandioxid beinhalten und die Beschichtung einen brennbaren Absorber, der im wesentlichen aus Zirconiumdiborid besteht, aufweist, dadurch gekennzeichnet, daß die palette, welche obere und untere abgeschirmten Teile aufweist, im wesentlichen aus rostfreiem Stahl besteht.

3. Vorrichtung nach Anspruch 1 oder 2, dadurch gekennzeichnet, daß die Brennstofftabletten in der Palette etwa Ende an Ende in Spalten ausgerichtet und etwa Seite an Seite in Reihen ausgerichtet sind, und daß die Palette, wenn sie abnehmbar auf der Trommel innerhalb des offenen Bereichs deren Umfangs montiert ist, so ausgerichtet ist, daß jede Spalte etwa in einer Ebene und parallel zur Längsachse der Trommel verläuft, wobei die abgeschrmten Teile mit so Abstand angeordnet sind, daß die Brennstofftabletten innerhalb der Palette gleitund rollfähig liegen.

4. Vorrichtung nach Anspruch 3, dadurch gekennzeichnet, daß die Palette etwa parallel angeordnete Seitenwände zum seitlichen Halten der Brennstofftabletten-Reihen in der Palette aufweisen, wobei der Raum zwischen den Seitenwänden so ausgelegt ist, daß, wenn irgendeine der Tablettenreihen gegen eine der Seitenwände angedrückt würde, ein Spalt von ungefähr 0,8 Millimeter bis 1,5 Millimeter zwischen dieser Tablettenreihe und der anderen Palettenseitenwand entstehen würde.

5. Vorricntung nach Anspruch 4, wobei jede Tablette einen Durchmesser von ungefähr 8,2 Millimeter aufweist, dadurch gekennzeichnet, daß der Spalt ungefähr 1,2 Millimeter beträgt.

6. Vorrichtung nach einem der Ansprüche 3, 4 oder 5, dadurch gekennzeichnet, daß jedes der abgeschirmten Teile ein Abschirm-Gittermuster aufweist, das so verläuft, daß eine jeweils auf ein Abschirm-Gittermuster projezierte Tablettenspalte einen Winkel zwischen ungefähr 5 Grad und 40 Grad mit diesem bildet.

7. Vorrichtung nach Anspruch 6, dadurch gekennzeichnet, daß der Winkel ungefähr 15 Grad beträgt.

8. Vorrichtung nach einem der vorstehenden Ansprüche, dadurch gekennzeichnet, daß während des Aufstäubens der Beschichtung, die Kammer, in welcher die Trommel angeordnet ist, bezüglich der Horizontalen um einen Winkel nicht größer als 10 Grad schräggestellt ist.

9. Vorrichtung nach Anspruch 8, dadurch gekennzeichnet, daß der Winkel ungefähr 5 Grad beträgt.

10. Vorrichtung nach einem der vorstehenden Ansprüche, dadurch gekennzeichnet, daß die Trommel mehrere offene Bereiche in deren Umfang aufweist, wobei jeder zur Aufnahme einer Palette dient, und alle etwa gleich sind und mit Abstand entlang des Umfangs der Trommel angeordnet sind.

11. Vorrichtung nach einem der vorstehenden Ansprüche, dadrch gekennzeichnet, daß die Zerstäubungsmttel mehrere obere und untere Targets aufweisen, wobei die oberen Targets Spritzdüsen stationär mit Umfangsabstand zueinander befestigt sind, und die unteren Targets stationär mit Umfangsabstand zueinander befestigt sind.

12. Vorrichtung nach Anspruch 11, dadurch gekennzeichnet, daß mindestens eines der oberen Targets und mindestens eines der unteren Targets aus einem ersten Material zum Aufstäuben der Beschichtung auf die Brennstofftabletten und mindestens eines der oberen Targets und eines der unteren Targets aus einem zweiten und davon verschiedenen Material zum Aufstäuben einer weiteren Beschichtung auf die erstere Beschichtung bestehen, wobei die Vorrichtung Steuermittel zur Steuerung der Antriebsmittel der Trommel und der Zerstäubungsmittel aufweist, und wobei die Steuerung so angepaßt ist, daß für eine bestimmte Zeit zuerst die oberen und unteren Targets mit dem ersten Material und dann für eine bestimmte Zeit die oberen und unteren Targets mit dem zweiten Material aktiviert werden.

13. Vorrichtung nach einem der vorstehenden Ansprüche, dadurch gekennzeichnet, daß die oberen und unteren Targets mehrere etwa identische Targetplatten aufweisen, welche untereinander auswechselbar sind.

**Revendications**

1. Appareil servant à déposer un revêtement sur des pastilles de combustible nucléaire, caractérisé en ce qu'il est constitué par la combinaison des éléments suivants:

(a) un tambour creux de forme générale cylindrique dont la circonférence comporte au moins une zone ouverte;

(b) une palette destinée à recevoir des pastilles de combustible à revêtir, ladite palette comportant une paire de parties grillagées qui sont attachées l'une à l'autre face à face de manière amovible afin de définir entre elles un espace servant à loger les pastilles de combustible, ledit espace ayant une profondeur permettant d'y placer les pastilles de combustible en une seule couche uniquement, ladite palette pouvant être montée de manière amovible à l'intérieur dudit espace ouvert de la circonférence du tambour de sorte que les parties grillagées soient tournées dans des directions sensiblement radiales par rapport au tambour;

(c) une chambre pouvant être fermée de manière étanche dans laquelle le tambour peut être placé et hors de laquelle il peut être retiré, ledit tambour étant supporté dans ladite chambre de manière à ce que son axe longitudinal soit généralement horizontal, des moyens d'entraînement étant associés audit tambour pour faire tourner ce dernier autour de son axe longitudinal; et

(d) des moyens servant à déposer ledit revêtement par pulvérisation sur les pastilles de combustible contenues dans la palette montée de manière amovible sur le tambour, les moyens de pulvérisation comportant au moins une cible supérieure et au moins une cible inférieure, lesquelles sont supportées de manière à être stationnaires à des emplacements leur permettant de déposer un revêtement par pulvérisation sur les pastilles de combustible situées à l'intérieur de ladite palette pendant que le tambour tourne, l'agencement étant tel que, lorsque le tambour se trouve à l'intérieur de ladite chambre, ladite cible supérieure ou chaque cible supérieure est positionnée à l'intétreiur de tambour à un niveau situé au-dessus de l'axe longitudinal et à proximité de la circonférence du tambour, et qu'elle est orientée de façon à étre tournée généralement vers le haut et radialement vers l'extérieur du tambour, et que ladite cible inférieure ou chaque cible inférieure est positionnée à l'extérieur et en dessous du tambour à proximite de sa circonférence, et qu'elle est orientée de façon à être tournée généralement vers le haut et radialement vers l'intérieur du tambour.

2. Appareil selon la revendication 1, dans lequel les pastilles de combustible comportent du bioxyde d'uranium et le revêtement comprend un absorbeur combustible essentiellement composé de diborure de zirconium, caractérisé en ce que ladite palette, y compris lesdites parties grillagées supérieure et inférieure, est réalisée essentiellement en acier inoxydable.

3. Appareil selon la revendication 1 ou la revendication 2, caractérisé en ce que les pastilles de combustibles situées à l'intérieur de ladite palette sont alignées généralement bout à bout en colonnes et alignées généralement côte en rangées, et en ce que ladite palette, lorsqu'elle est montée de manière amovible sur le tambour à l'intérieur de ladite zone ouverte dans la circonférence de celui-ci, est orientée de manière à que chacune desdites colonnes soit généralement coplanaire avec, et parallèle à, l'axe longitudinal dudit tambour, lesdites parties grillagées étant espacées l'une de l'autre d'une distance permettant auxdites pastilles de combustible de s'adapter dans le palette de façon à pouvoir glisser et rouler à l'intérieur de la palette.

4. Appareil selon la revendication 3, caractérisé en ce que ladite palette comporte des côés généralement parallèles espacés pour retenir les rangées de pastilles de combustible latéralement dans la palette, l'espacement entre lesdits côtés étant tel que, si une des rangées de pastilles était solicitée contre l'un desdits côtés, il existerait un écart d'environ 0,8 mm à 1,5 mm entre ladite rangée de pastilles et le second desdits côtés de la palette.

5. Appareil selon la revendication 4, dans lequel chaque pastille a un diamètre d'environ 8,2 mm, caractérisé en ce que ledit écart est d'environ 1,2 mm.

6. Appareil selon la revendication 3, 4 ou 5, caractérisé en ce que chacune desdites parties grillagées présente un dessin de grille ayant une orientation telle que l'une quelconque desdites colonnes de pastilles projetée sur chaque dessin de grille définisse un angle compris entre environ 5 et 40 degrés par rapport à ce dernier.

7. Appareil selon la revendication 6, caractérisé en ce que ledit angle est d'environ 15 degrés.

8. Appareil selon l'une quelconque des revendications précédentes, caractérisé en ce que, pendant la pulvérisation du revêtement, ladite chambre, renfermant ledit tambour, est inclinée par rapport à l'horizontale sous un angle n'excédant pas 10 degrés.

9. Appareil selon la revendication 8, caractérisé en ce que ledit angle est d'environ 5 degrés.

10. Appareil selon l'une quelconque des revendications précéentes, caractérisé en ce que ledit tambour comporte une pluralité de zones ouvertes dans sa circonférence, chacune étant destinée à recevoir l'une desdites palettes, lesdites zones ouvertes étant sensiblement identiques les unes aux autres et espacées les unes des autres circonférentiellement autour du tambour.

11. Appareil selon l'une quelconque des revendications précédentes, caractérisé en ce que les moyens de pulvérisation comprennent une multiplicité de chacune desdites cibles supérieure et inférieure, les cibles supérieures étant supportées de manière à être stationnaires et espacées circonférentiellement les unes des autres, et les cibles inférieures étant supportées de manière à être stationnaires et espacées circonférentiellement les unes des autres.

12. Appareil selon la revendication 11, caractérisé en ce qu'au moins l'une des cibles supérieures et au moins l'une des cibles inférieures comprennent un premier matériau pour la déposition par pulvérisation dudit revêtement sur les pastilles de combustible, et en ce qu'au moins l'une des cibles supérieures et l'une des cibles inférieures comprennent un second matériau, différent, pour la déposition par pulvérisation d'un revêtement supplémentaire sur le revêtement précité, ledit appareil comprenant des moyens de commande servant à commander lesdits moyens d'entraînement du tambour et lesdits moyens de pulvérisation, lesdits moyens de commande étant prévus pour activer pendant une période prédéterminée d'abord les cibles supérieures et inférieures comprenant le ledit premier matériau, et ensuite pour activer pendant une période présélectionnée les cibles supérieures et inférieures comprenant ledit second matériau.

13. Appareil selon l'une quelconque des revendications précédentes, caractérisé en ce que chacune desdites cibles supérieure et inférieure comprend une multiplicité de tuiles de cible sensiblement identiques dont les positions sont mutuellement interchangeables.

FIG. 1

FIG. 2

FIG. 3

FIG. 4

FIG. 5

FIG. 6

FIG. 7

FIG. 8

FIG. 9